# FASCICULE DE BREVET EUROPEEN

(11) **EP 0 320 355 B1**
(45) Date de publication et mention de la délivrance du brevet: **24.03.1993**
(21) Numéro de dépôt: 88403068.5
(22) Date de dépôt: 05.12.1988
(51) Int. Cl.: H01H 50/14, H02B 1/04

(54) **Socle de contacteur de puissance à broches**
Sockel für Leistungsschutz mit Steckern
Socket for a power contactor with plugs

(30) Priorité: 11.12.1987 FR 8717290
(43) Date de publication de la demande: 14.06.1989
(73) Titulaire: AUXILEC, F-78400 Chatou (FR)
(72) Inventeur: Vauban, Jean, F-75008 Paris (FR); Salvaudon, Gilles, F-75008 Paris (FR)
(74) Mandataire: Ruellan-Lemonnier, Brigitte

(56) Documents cités:
- EP-A- 0 208 185
- GB-A- 826 324
- US-A- 3 328 648

## Description

L'invention concerne les contacteurs de puissance à broches et, plus particulièrement dans ces contacteurs, la partie femelle qui constitue le socle sur lequel vient s'embrocher et se fixer la partie mâle.

Les contacteurs de puissance sont utilisés dans de nombreux domaines pour réaliser des connexions électriques entre deux éléments qui sont, d'une part, plusieurs sources d'alimentation électrique et, d'autre part, un circuit de distribution de la puissance électrique à différents organes. Les caractéristiques de ces contacteurs,qui sont en fait des relais de puissance, dépendent bien entendu de la puissance électrique qu'ils doivent être capables de transmettre sans se détériorer ainsi que des conditions de l'environnement. C'est ainsi qu'en aéronautique, les puissances électriques sont transmises sous une relativement faible tensionet il en résulte donc des intensités de courant très importantes qui échauffent d'une façon générale les conducteurs électriques mais plus particulièrement les contacts du contacteur, notamment lorsque la liaison électrique entre lesdits contacts n'est pas parfaite.

Cette mauvaise liaison électrique au niveau des contacts peut provenir de divers facteurs tels que l'absence d'homogénéité des surfaces en regard,la détérioration du contact électrique entre les surfaces en regard due aux modifications de l'environnement : humidité, vibrations et le vieillissement rapide des éléments mécaniques dû aux vibrations et aux échauffements locaux fréquents. En outre, les contacteurs de puissance sont en général lourds et relativement volumineux de sorte qu'il est difficile de les monter par des connexions à broches et douilles sans rencontrer des difficultés de tenue mécanique notamment en cas de vibrations.

Il est connu de l'homme de l'art des dispositifs permettant d'améliorer le contact entre les parties mâle et femelle d'un même connecteur. Ainsi, le brevet anglais GB-A-826 324 décrit-il différents joints élastiques métalliques permettant de serrer la broche de la partie mâle d'un connecteur à l'intérieur de la douille de la partie femelle dudit connecteur. Les joints décrits dans ce brevet sont métalliques. Ils sont introduits dans les douilles de façon à améliorer le contact mécanique et électrique entre la broche et la douille.

Un but de la présente invention est donc de réaliser un socle pour contacteur de puissance à broches, ledit socle constituant la partie femelle du connecteur, qui permet d'obtenir et de maintenir un excellent contact électrique avec les broches de la partie mâle portées par le contacteur même dans le cas où il est soumis à des vibrations de manière continue.

Par ailleurs, ce socle de contacteur constitue les bornes d'entrée et de sortie de la puissance électrique à distribuer aux divers appareils électriques de bord et il est important de détecter les défauts et les pannes qui peuvent affecter lesdits appareils, défauts et pannes qui se traduisent souvent par des surintensités et des surtensions sur les conducteurs d'alimentation.

Des dispositifs de mesure de surintensités ou de surtensions sur un contacteur sont connus de l'homme de l'art comme, par exemple, celui décrit dans le brevet américain US-A-3 328 648. L'endroit idéal pour mesurer des surintensités sur un contacteur selon l'invention se situe sur le socle du contacteur.

Aussi, un autre but de la présente invention est de réaliser un socle pour contacteur de puissance à broches qui comprend des moyens de mesure des surintensités.

L'invention se rapporte à un socle de contacteur de puissance à broches tel que défini dans la revendication 1.

D'autres modes de réalisation de l'invention sont définis dans les revendications dépendantes.

Selon un mode de réalisation, le socle comprend une embase qui est munie de moyens, tels que des pieds, sur lesquels vient se fixer de manière démontable le contacteur.

Une telle disposition permet d'assurer un bon contact électrique entre les parties mâle et femelle même en présence de vibrations importantes.

D'autres caractéristiques et avantages de la présente invention apparaîtront à la lecture de la description suivante d'un exemple particulier de réalisation, ladite description étant faite en relation avec les dessins joints dans lesquels :
- la figure 1 est une vue d'ensemble d'un contacteur de puissance et de son socle de support selon l'invention,
- la figure 2 est une vue de dessus du socle du contacteur de puissance selon l'invention,
- la figure 3 est une vue en coupe du socle de contacteur de puissance suivant la ligne III-III de la figure 2 et,
- la figure 4 est une vue en coupe détaillée d'une douille femelle du socle de contacteur selon l'invention.

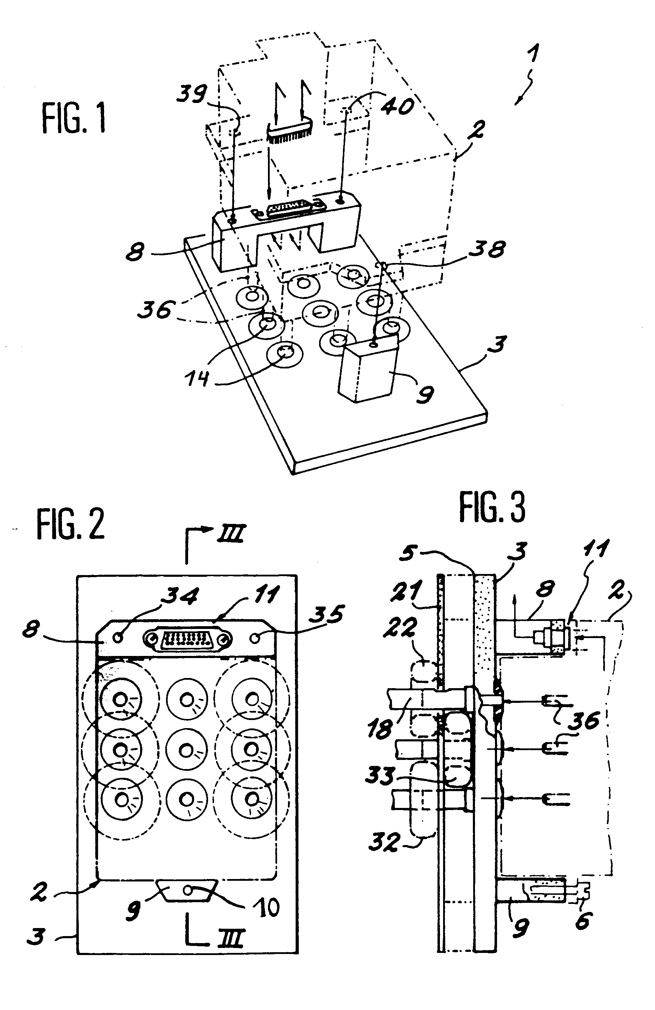

La figure 1 montre un contacteur de puissance 1 qui comprend un boîtier ou partie mâle 2 et son socle de support 3. Ce boîtier 2 contient un relais (non représenté) qui permet d'aiguiller l'énergie électrique reçue sous forme triphasée sur les trois bornes de gauche ou sur les trois bornes de droite (bornes d'entrée) vers les trois bornes centrales qui constituent les bornes de sortie, vers un appareil de distribution électrique dont fait partie le socle ou partie femelle 3.

Dans un aéronef, l'énergie électrique peut provenir de diverses sources d'alimentation que sont deux générateurs principaux qui ne fonctionnent que lorsque les moteurs de l'aéronef sont en marche, un générateur de piste d'envol pour le démarrage des moteurs et un générateur auxiliaire de bord qui ne fonctionne qu'en l'absence du générateur de piste.

Dans un tel aéronef, il est prévu plusieurs contacteurs de puissance du type de la figure 1 de manière à choisir les sources d'alimentation électrique et à aiguiller l'énergie électrique vers les deux réseaux de distribution de l'aéronef.

Les bornes d'entrée-sortie du boîtier ou partie mâle 2 sont constituées par des broches 36 qui viennent se loger dans des douilles 14 du socle ou partie femelle 3. Ces broches 36 sont solidaires du boîtier et ne seront pas décrites plus précisément car elles ne font pas partie de l'invention. Le boîtier 2 présente extérieurement et latéralement des pattes de fixation 38, 39 et 40 qui coopèrent avec des pieds 8 et 9 solidaires du socle 3 par l'intermédiaire de trous taraudés dans les pieds 8 et 9 et de vis traversant les pattes de fixation. Seule la vis 6 associée au pied 9 a été représentée (figure 3).

Comme le montrent les figures 2 et 3, le socle 3 comprend une embase 5 en matériau isolant qui est percée de neufs trous tels que celui référencé 12, trous qui servent de logement aux douilles femelles 14. Le socle 3 présente, du côté du boîtier 2, deux pieds 8 et 9 de support et de maintien de ce boîtier qui sont fixés sur l'embase. A cet effet, ces pieds sont percés de trous taraudés 34 et 35 pour le pied 8 et 10 pour le pied 9 dans lesquels viennent se visser des vis associées au boîtier 2. Le pied 8 a la forme d'un U dont les branches latérales sont fixées à l'embase. La branche transversale est prévue pour recevoir un connecteur multibroches dans une prise 11 pour courants faibles.

Le socle 3 peut être fixé de manière démontable sur la coque de l'appareil de distribution électrique par des moyens appropriés (non représentés), ce qui facilite l'assemblage initial.

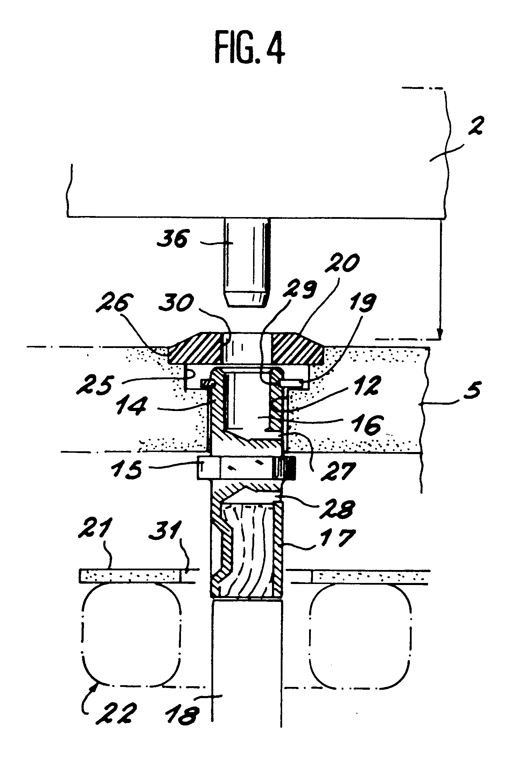

Comme le montre de manière plus détaillée la figure 4, chaque contact femelle comprend les éléments suivants. D'abord un trou 12 percé dans l'embase 5 et deux alésages 25 et 26 de diamètre supérieur à celui du trou 12 disposés du côté du contact mâle. Dans ce trou et l'alésage 25 est disposée une douille 14 comportant une partie supérieure creuse 16 et une partie inférieure creuse 17 séparées par une partie pleine formant une collerette 15. Le fond de chaque partie creuse est percé d'un trou 27 ou 28 qui sert à évacuer l'eau et les saletés qui peuvent s'accumuler dans le fond.

La partie inférieure 17 est un cylindre de révolution et sert à établir le contact électrique avec un conducteur 18 souple multibrins, par exemple par sertissage. La partie supérieure 16, également un cylindre de révolution, est prévue pour coopérer avec une broche mâle 36. Vers l'extrémité supérieure de la partie 16, la paroi externe de la douille 14 est munie d'une rainure circulaire 29 pour accommoder un anneau élastique ou clip 19. Cet anneau 19 sert à retenir en place la douille 14 dans le trou 12 tout en lui permettant un certain déplacement vertical limité vers le bas. La collerette 15 joue un rôle semblable pour limiter le déplacement vers le haut de la douille 14. Pour des raisons évidentes, l'épaisseur de la paroi de la partie supérieure 16 est plus forte que celle de la partie inférieure 17.

La partie supérieure 16 est coiffée d'un joint élastique 20 qui s'encastre dans le premier alésage 26, ce joint présentant une ouverture centrale circulaire 30 dont le centre est sur l'axe de révolution de la douille. La face supérieure du joint 20 est chanfreinée sur son pourtour. La face inférieure du joint affleure le pourtour supérieur arrondi de la douille 14. L'épaisseur du joint annulaire élastique 20 est plus grande que la profondeur du premier alésage 26 de manière que le joint 20 par déformation élastique vienne presser la douille 14 et l'immobiliser dans sa position de travail par blocage de l'anneau 19 contre l'épaulement du second alésage 25 lorsque la partie mâle à broches ou boitier 2 est maintenue pressée contre l'embase 5 de la partie femelle ou socle 3.

La partie inférieure 17 se prolonge vers le bas par le câble multibrins 18 qui traverse par un trou 31 une plaque 21 qui sert de support à des bobinages toriques tels que ceux référencés 22, 32 et 33 (figures 4 et 3). Chaque bobinage torique entoure un conducteur et est utilisé pour mesurer l'intensité de courant qui y circule. Comme le montre la figure 3, les bobinages toriques 22 et 32, associés aux conducteurs extrêmes, sont disposés d'un côté de la plaque 21, celui éloigné du socle 3 tandis que le bobinage 33, associé au conducteur central, est disposé entre la plaque 21 et l'embase 5. La plaque 21 est maintenue en place par rapport au socle 3 par tous moyens appropriés.

Cette plaque 21 peut être par exemple une plaque pour support de circuits imprimés et est donc relativement rigide. La douille 14 est en cuivre et la paroi interne de la partie supérieure 16 est recouverte d'une fine couche d'or pour améliorer le contact entre la partie mâle 36 et la douille 14. Le socle 3 est réalisé en des matériaux composites qui sont connus sous les appellations de RITON et de DELMAT. Le clip 19 est de préférence en acier et le joint élastique 20 est réalisé en un composé élastomère.

Les contacts mâles 36 du contacteur 2 s'emmanchent dans les douilles correspondantes 14, les douilles étant repoussées vers le bas jusqu'à ce que le clip 19 s'appuie sur l'épaulement de l'alésage 25. La face inférieure du boîtier 2 (côté contacts mâles) vient s'appuyer sur les joints élastiques 20 dont le pourtour de l'ouverture centrale se déplace vers la douille et vient la bloquer en position basse ou position de travail tout en laissant un certain débattement dû à l'élasticité du joint. Le boîtier 2 est maintenu en position par des vis qui lui sont associées et qui viennent se visser dans les trous taraudés 10, 34 et 35 portés par les pieds 8 et 9.

Bien entendu, les trous taraudés 10, 34 et 35 et les vis correspondantes peuvent être remplacés par tous autres moyens équivalents qui assurent une fixation démontable.

Par cette disposition des différents éléments et leur montage, on obtient un meilleur contact entre les deux parties mâle et femelle du contacteur mais aussi une meilleure tenue mécanique de l'ensemble, notamment en cas de vibrations comme c'est la cas sur les aéronefs. En outre, on peut,non seulement, monter et démonter facilement le boîtier 2 par rapport au socle 3 mais aussi monter et démonter relativement facilement les douilles 14 car il suffit d'enlever le joint élastique 20 pour avoir accès au clip 19. Lorsque le clip 19 est retiré, la douille 14 peut être enlevée en tirant sur le conducteur qui lui est connecté. Un tel aspect facilite la maintenance de l'appareil.

## Revendications

1. Socle (3) de partie femelle à douilles (14) d'un contacteur (1) de puissance du type à partie mâle (2) à broches (36), ayant, au niveau de chaque douille (14), côté broches, un premier alésage (26) coaxial au trou de logement (12) de la douille (14), caractérisé en ce que ledit premier alésage (26) contient un joint annulaire élastique (20) dont l'épaisseur est plus grande que la profondeur dudit premier alésage (26), ledit joint (20) permettant par sa déformation élastique de presser et d'immobiliser ladite douille (14) dans sa position de travail lors d'un assemblage de la partie mâle (2) et de la partie femelle du contacteur (1).

2. Socle (3) selon la revendication 1, caractérisé en ce qu'il comprend une embase plate (5) qui est percée d'une pluralité desdits trous de logement (12), chaque trous (12) se terminant, côté broches, par un second alésage (25) et ledit premier alésage (26), le second alésage (25) ayant un diamètre inférieur à celui du premier alésage (26), une douille (14) qui est emmanchée dans chaque trou (12) et qui comporte à ses deux extrémités une partie cylindrique creuse, l'une (16) pour accommoder la broche (36) correspondante et l'autre (17) pour effectuer la connexion avec un conducteur (18), ladite douille étant pourvue, côté conducteur, d'une collerette extérieure (15) qui sert de butée contre l'embase (5), et côté broches, d'une rainure circulaire extérieure (29) pour loger un anneau élastique ou clip (19) qui sert de retenue en venant en butée contre l'épaulement du second alésage (25).

3. Socle (3) selon la revendication 2, caractérisé en ce que le joint annulaire élastique (20) a une épaisseur choisie de façon à bloquer l'anneau élastique (19) contre l'épaulement du second alésage (25) lorsque la partie mâle (2) est maintenue pressée contre l'embase (5).

4. Socle (3) selon l'une quelconque des revendications 2 ou 3, caractérisé en ce que l'embase (5) est munie de moyens de fixation (8, 9, 10, 34, 35) de la partie mâle (2).

5. Socle (3) selon la revendication 4, caractérisé en ce que les moyens de fixation sont constitués par des pieds (8 et 9) portés par l'embase (5) et sur lesquels vient reposer la partie mâle (2).

6. Socle (3) selon l'une quelconque des revendications 2 à 5, caractérisé en ce que les conducteurs (18) munis de leur douille (14) sont montés au travers de bobinages toriques (22, 32, 33) qui servent à mesurer les intensités de courant circulant dans lesdits conducteurs (18).

7. Socle (3) selon la revendication 2, caractérisé en ce que les parties creuses (16, 17) des douilles (14) comprennent au niveau de leur fond des trous d'évacuation (27, 28).

## Claims

1. Baseplate (3) for female socket part (14) of a connector (1) for power of the type with a male part (2) with pins (36), having, in the region of each socket (14) on the pin side, a first bore (26) coaxial with the hole (12) for housing the socket (14), characterised in that the said first bore (26) contains an elastic annular seal (20) whose thickness is greater than the depth of the said first bore (26), the said seal (20) allowing, by its elastic deformation, the said socket (14) to be pressed and immobilised in its working position during assembly of the male part (2) and of the female part of the connector (1).

2. Baseplate (3) according to Claim 1, characterised in that it comprises a flat base part (5) which is pierced with a plurality of the said housing holes (12), each hole (12) ending, on the pin side, in a second bore (25) and the said first bore (26), the second bore (25) having a diameter less than that of the first bore (26), a socket (14) which is fitted into each hole (12) and which comprises a hollow cylindrical part at its two ends, one (16) to accommodate the corresponding pin (36) and the other (17) to perform the connection with a conductor (18), the said socket being provided, on the conductor side, with an external collar (15) which acts as a stop against the base part (5), and on the pin side, with an external circular groove (29) to house an elastic ring or clip (19) which acts as a retainer by coming into abutment against the shoulder of the second bore (25).

3. Baseplate (3) according to Claim 2, characterised in that the elastic annular seal (20) has a thickness which is chosen so as to lock the elastic ring (19) against the shoulder of the second bore (25) when the male part (2) is held pressed against the base part (5).

4. Baseplate (3) according to either one of Claims 2 or 3, characterised in that the base part (5) is equipped with means (8, 9, 10, 34, 35) for fastening the male part (2).

5. Baseplate (3) according to Claim 4, characterised in that the fastening means consist of feet (8 and 9) carried by the base part (5) and on which the male part (2) rests.

6. Baseplate (3) according to any one of Claims 2 to 5, characterised in that the conductors (18) equipped with their socket (14) are mounted through toric windings (22, 32, 33) which act to measure the intensities of current flowing in the said conductors (18).

7. Baseplate (3) according to Claim 2, characterised in that the hollow parts (16, 17) of the sockets (14) comprise evacuation holes (27, 28) at their bottom.

## Patentansprüche

1. Mit Buchsen (14) versehener Sockel (3) eines Leistungsschaltglieds (1) in Verbindung mit einem mit Stiften (36) versehenen Stiftteil (2), wobei der Buchsenteil in Höhe jeder Buchse (14) und den Stiften zugewandt eine erste Bohrung (26) aufweist, die koaxial zu dem Loch (12) verläuft, in dem die Buchse (14) sitzt, dadurch gekennzeichnet, daß die erste Bohrung (26) einen elastischen Dichtungsring (20) enthält, dessen Dicke größer als die Tiefe der ersten Bohrung (26) ist und die durch ihre elastische Verformung die Buchse (14) in ihre Arbeitsstellung drücken und dort halten kann, wenn der Stiftteil (2) und der Buchsenteil des Schaltglieds (1) zusammengesteckt werden.

2. Sockel (3) nach Anspruch 1, dadurch gekennzeichnet, daß er eine flache Basis (5) enthält, die eine Vielzahl von Buchsenlöchern (12) besitzt, die auf der Seite der Stifte in je einer zweiten Bohrung (25) und in der ersten Bohrung (26) endet, wobei die zweite Bohrung (25) einen geringeren Durchmesser als die erste Bohrung (26) besitzt und wobei eine Buchse (14) in jedes Loch (12) eingesetzt ist, die an ihren beiden Enden je einen hohlen zylindrischen Bereich besitzt, nämlich einen Bereich (16), um den entsprechenden Stift (36) aufzunehmen, und den anderen Bereich (17), um den Anschluß an einen Leiter (18) durchzuführen, wobei die Buchse auf der Seite des Leiters einen Außenkragen (15), der als Anschlag gegen die Basis (5) dient, und auf der Seite der Stifte eine äußere ringförmige Rinne (29) enthält, um eine elastischen Ring oder Clip (19) aufzunehmen, der als Halteorgan in Anschlag gegen die Schulter der zweiten Bohrung (25) dient.

3. Sockel (3) nach Anspruch 2, dadurch gekennzeichnet, daß der elastische Dichtungsring (20) eine Dicke hat, die so gewählt ist, daß der elastische Ring (19) an der Schulter der zweiten Bohrung (25) anliegt, wenn der Stiftteil (2) gegen die Basis (5) drückt.

4. Sockel (3) nach einem beliebigen der Ansprüche 2 oder 3, dadurch gekennzeichnet, daß die Basis (5) Befestigungsmittel (8, 9, 10, 34, 35) für den Stiftteil (2) besitzt.

5. Sockel (3) nach Anspruch 4, dadurch gekennzeichnet, daß die Befestigungsmittel von Füßen (8, 9) gebildet werden, die auf der Basis (5) sitzen und auf denen sich der Stiftteil (2) abstützt.

6. Sockel (3) nach einem beliebigen der Ansprüche 2 bis 5, dadurch gekennzeichnet, daß die Leiter (18) mit ihrer Buchse (14) durch ringförmige Wicklungen (22, 32, 33) hindurch montiert sind, die zur Messung der in den Leitern (18) fließenden Ströme dienen.

7. Sockel (3) nach Anspruch 2, dadurch gekennzeichnet, daß die hohlen Bereiche (16, 17) der Buchsen (14) in Höhe ihres Grundes Ableitungslöcher (27, 28) besitzen.
